# EUROPEAN PATENT APPLICATION

(11) **EP 2 037 289 A1**
(43) Date of publication of application: **18.03.2009**
(21) Application number: 08252890.2
(22) Date of filing: 29.08.2008
(51) Int. Cl.: G01R 31/36, H01M 10/42

(54) **Internal state estimating device of secondary battery**

(30) Priority: 14.09.2007 JP 2007239756
(71) Applicant: Calsonic Kansei Corporation, Tokyo 164-8602 (JP)
(72) Inventor: Kobayashi, Shiniya c/o Calsonic Kansei Corporation, Nakano-Ku Tokyo 164-8602 (JP); Hirota, Yukitsugu c/o Calsonic Kansei Corporation, Nakano-Ku Tokyo 164-8602 Japan (JP); Aoki, Toru c/o Calsonic Kansei Corporation, Nakano-Ku Tokyo 164-8602 Japan (JP)
(74) Representative: Oxley, Robin John George

(57) **Abstract**

An internal-state estimating device of a secondary battery (5) has an electric current detecting means (7, 8; 15), a secondary-battery terminal voltage detecting means (9), a running state judging means (10; 14), an electric-current random-noise impressing means (12) and a secondary-battery internal-state estimating means (13). The electric current detecting means (7, 8; 15) detects an electric current for a vehicle drive motor (2) and a load-motor (3) as one of a total current thereof and each current thereof. The running state judging means (10; 14) judges a substantially constant vehicle-speed running state of a motor vehicle. The electric-current random-noise impressing means (12) superimposes a random noise on a load-motor electric current when the running state judging means (10; 14) judges the substantially constant vehicle-speed running state. The secondary-battery internal-state estimating means (13) estimates an internal-state based on the terminal voltage and the current including the load-motor current and superimposed with the random noise at the substantially constant vehicle-speed running state.

## Description

The present invention relates to an internal state estimating device of a secondary battery that is installed on a motor vehicle such as a hybrid electric vehicle and an electric vehicle.

A conventional internal state estimating device of a secondary battery is disclosed in Japanese patent laying-open publication No. 2004 - 178848. This conventional internal state estimating device of a secondary battery estimates an internal state, such as a charging rate and an internal resistance, of the secondary battery by using an adaptive digital filter, based on a charge current, a discharging current and a terminal voltage. Then an open circuit voltage is estimated based on the estimated internal state, and a charging rate, namely a State of Charge (SOC) is estimated by using data on characteristics between the open circuit voltage and the charging rate.

Another conventional internal state estimating device of a secondary battery is disclosed in Japanese patent laying-open publication No. 2000 - 323183. This conventional internal estimating device of a secondary battery approximates a detected electric current and a voltage by using a current-voltage characteristic line, and it estimates a gradient of the line as an internal resistance, also an intercept thereof as an open circuit voltage.

The above known conventional internal state estimating devices of the secondary batteries, however, encounter a problem in that it is difficult to estimate the internal state of the secondary battery with a high degree of accuracy when a motor vehicle runs at a substantially constant vehicle speed on a long and flat road and/or an express highway, because an electric current supplied to a drive motor very slightly changes due to a substantially constant rotational speed of the drive motor.

It is, therefore, an object of the present invention to provide an internal state estimating device of a secondary battery which overcomes the foregoing drawbacks and can estimate an internal state of a secondary battery with a higher degree of accuracy even while a motor vehicle is running at a substantially constant vehicle speed.

According to a first aspect of the present invention there is provided an internal state estimating device of a secondary battery, the estimating device including an electric current detecting means, a secondary-battery terminal voltage detecting means, a running state judging means, an electric-current random-noise impressing means and a secondary-battery internal-state estimating means. The electric current detecting means detects one of a total electric current, of a vehicle drive motor electric current to be supplied to a vehicle drive motor and a load-motor electric current to be supplied to a load-motor, and each electric current thereof. The electric current detecting means detects an electric current to be supplied to a vehicle drive motor and a load motor as one of a total electric current thereof and each electric current thereof. The secondary-battery terminal voltage detecting means detects a terminal voltage of the secondary battery. The running state judging means judges a substantially constant vehicle-speed running state of a motor vehicle. The electric-current random-noise impressing means impresses a load-motor electric current, to be supplied to the load motor, superimposed with a random noise having a plurality of frequency components to the load motor when the running state judging means judges the substantially constant vehicle-speed running state. The secondary-battery internal-state estimating means estimates an internal state of the secondary battery based on the terminal voltage and the electric current that includes the load-motor electric current and is superimposed with the random noise when the running state judging means judges the substantially constant vehicle-speed running state.

Therefore, the internal state estimating device of the present invention can estimate the internal state of the secondary battery with a higher degree of accuracy even while the motor vehicle is running at the substantially constant vehicle speed.

The objects, features and advantages of the present invention will become apparent as the description proceeds when taken in conjunction with the accompanying drawings, in which:
FIG 1 is a schematic block diagram showing a control system of a motor vehicle for controlling a secondary battery, a vehicle drive motor and a compressor motor, which are used in an internal state estimating device of a secondary battery of a first embodiment according to the present invention;
FIG 2 is a schematic block diagram showing the internal state estimating device of the first embodiment;
FIG 3 is a schematic block diagram showing an internal state estimating part of the internal state estimating device of the first embodiment;
FIG 4 is a time chart showing a vehicle speed, a timer value and an electric current to be supplied to the compressor motor;

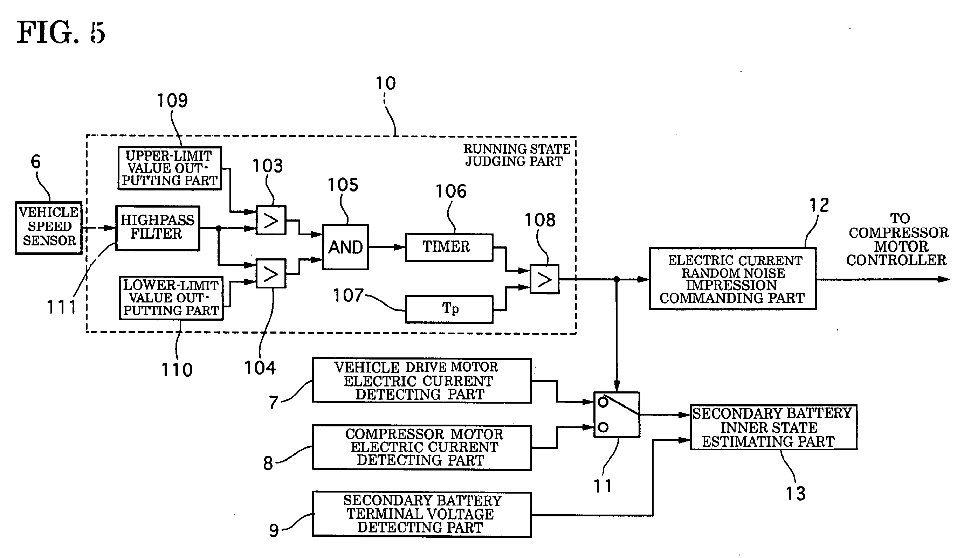

FIG 5 is a schematic block diagram showing a control system of a motor vehicle for controlling a secondary battery, a vehicle drive motor and a compressor motor, which are used in an internal state estimating device of a secondary battery of a second embodiment according to the present invention;
FIG. 6 is a time chart showing a vehicle speed, a vehicle speed after passing through a highpass filter, a timer value and an electric current to be supplied to a compressor motor;
FIG 7 is a schematic block diagram showing a control system of a motor vehicle for controlling a secondary battery, a vehicle drive motor and a compressor motor, which are used in an internal state estimating device of a secondary battery of a third embodiment according to the present invention;
FIG 8 is a diagram showing a relationship between a frequency and a gain;
FIG 9 is a schematic block diagram showing a control system of a motor vehicle for controlling a secondary battery, a vehicle drive motor and a compressor motor, which are used in an internal state estimating device of a secondary battery of a fourth embodiment according to the present invention; and
FIG 10 is a schematic bock diagram of an internal state estimating part of a battery controller of the internal state estimating device of the fourth embodiment.

Throughout the following detailed description, similar reference characters and numbers refer to similar elements in all figures of the drawings, and their descriptions are omitted for eliminating duplication.

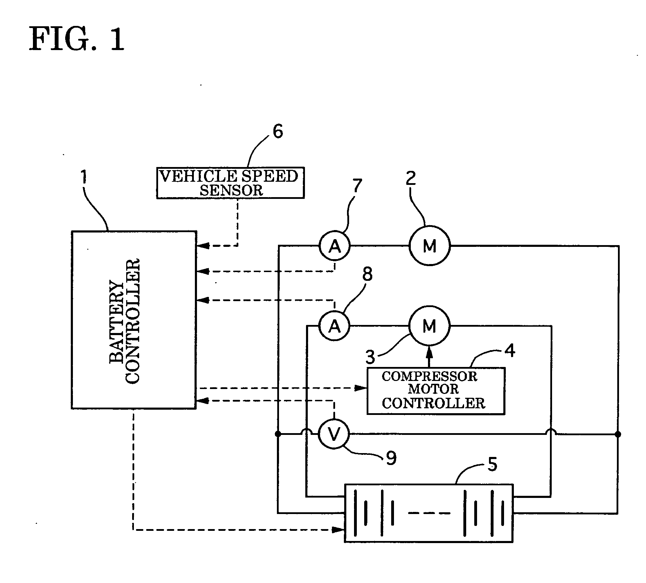

Referring to FIG 1 of the drawing, there is shown a control system of a motor vehicle, such as a hybrid electric vehicle and an electric vehicle, which is equipped with an internal state estimating device of a secondary battery of a first preferred embodiment according to the present invention.

The control system has a battery controller 1, a vehicle drive motor 2, a compressor motor 3, a compressor motor controller 4, a secondary battery 5, a vehicle speed detecting sensor 6, a drive-motor current detecting part 7, a compressor motor current detecting part 8 and a secondary-battery terminal voltage detecting part 9. The drive-motor current detecting part 7 and the compressor motor current detecting part 8 each corresponds to an electric current detecting means of the present invention. The secondary-battery terminal voltage detecting part 9 corresponds to a secondary-battery terminal voltage detecting means of the present invention.

The battery controller 1 estimates at least an internal state, such as SOC, of the secondary battery 5 based on a vehicle speed, a vehicle drive motor current, a compressor motor current and a secondary-battery terminal voltage to control charge and discharge of the secondary battery 5. It demands, according to the internal state of the secondary battery 5, the motor controller 4 to allow for the internal state thereof and execute a vehicle drive control.

The vehicle drive motor 2 serves as a driving source, for propelling the vehicle, which is supplied with electric power from the secondary battery 5. It employs a three-phase AC traction in this embodiment. Its controller and control method are similar to those of conventional hybrid electric vehicles, and their descriptions are omitted herein. Such a controller and a control method are disclosed in Japanese patent application Laid-open Publication No. 2005 - 120593 for example. In the hybrid electric vehicles, the vehicle drive motor 2 is controlled with an internal combustion engine to drive the motor vehicle.

The compressor motor 3 drives a not-shown compressor used for an air conditioner, and is supplied with electric power from the secondary battery 5 under control of the compressor motor controller 4.

The secondary battery 5 is an electric power supply for supplying the electric power to the vehicle drive motor 2 and the compressor motor 3. The second battery 5 employs a lithium-ion cell in this embodiment.

The vehicle speed sensor 6 detects a rotational speed of a drive-line or a wheel to output a rotational speed signal to the battery controller 1, which detects a vehicle speed based on the rotational speed signal.

The drive motor current detecting part 7 detects an electric current supplied to the vehicle drive motor 2, and outputs a drive current value signal to the battery controller 1.
The compressor-motor current detecting part 8 detects an electric current supplied to the compressor motor 3, and outputs a compressor current value signal to the battery controller 1.
The secondary-battery terminal voltage detecting part 9 detects a voltage between the terminals of the secondary battery 5, and outputs a voltage value signal to the battery controller 1.

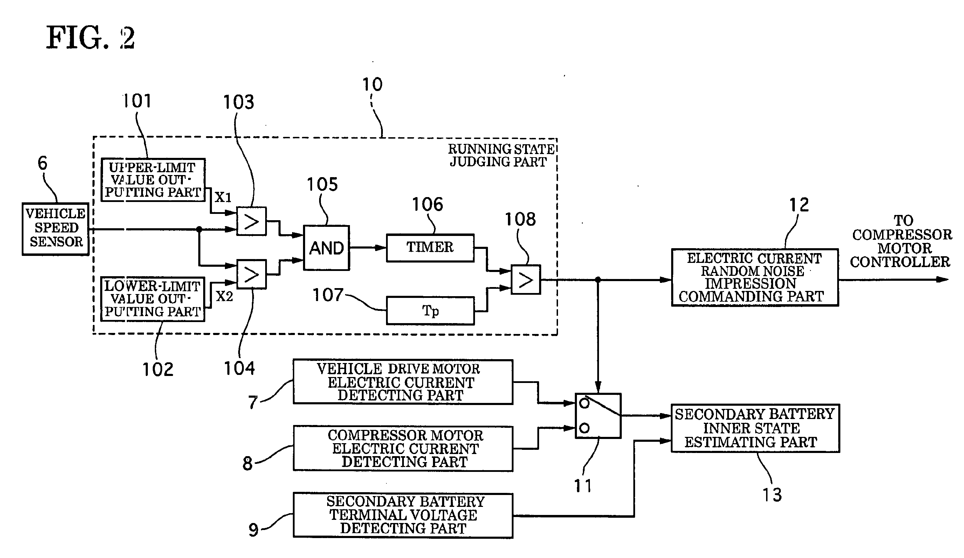

Referring to FIG. 2, there are shown blocks of the internal state estimating device of the first embodiment. The internal state estimating device is constructed by a part of the battery controller 1, and includes a vehicle running state judging part 10, a shifting part 11, an electric-current random-noise impression commanding part 12 and a secondary-battery internal state judging part 13. The vehicle running state judging part 10 corresponds to a vehicle running state judging means of the present invention, the electric-current random-noise impression commanding part 12 corresponds to a electric-current random-noise impression commanding means of the present invention, and the secondary-battery internal state judging part 13 corresponds to a secondary-battery internal state judging means of the present invention.

The vehicle running state judging part 10 judges a vehicle running state based on the vehicle speed to decide whether normal electric power is allowed to be outputted from the secondary battery 5 or a random noise is impressed on the compressor motor 3, thus outputting this decision signal to the shifting part 11 and the electric-current random-noise Impression commanding part 12. Specifically, the vehicle state is judged as follows.

When the detected vehicle speed becomes equal to or lower than an upper limit value X1 and also equal to or larger than a lower limit value X2, a timer 106 starts to count up and then continues with its counting as long as it is within the upper and lower limit values X1 and X2. If a timer value is larger than a predetermined time, the vehicle running state judging part 10 judges that the vehicle is running at a substantially constant speed on an express highway and the like, and it outputs a judgment signal "1" to impress the random noise on the compression motor 3. On the other hand, if the timer value is equal to or smaller than the predetermined time, it outputs the judgment signal "0" to allow the secondary battery 5 to supply a normal electric power. A detail structure of the vehicle running state judging part 10 will be later described.

The shifting part 11 shifts, based on the judgment signal outputted from the vehicle running state judging part 10, detection signals outputted from the vehicle drive motor current detecting part 7 and the compressor motor current detecting part 8 to be inputted to the secondary-battery internal state detecting part 13.

The electric-current random-noise impression commanding part 12 outputs a command signal to the compressor motor controller 4 so that normal electric power is impressed on the compressor motor 3 when the timer value is equal to or smaller than the predetermined time, while it outputs the command signal to the compressor controller 4 so that the normal electric power added with the random noise is impressed on the compressor motor 3 when the timer value is larger than the predetermined time.

The secondary-battery internal state estimating part 13 estimates the internal state of the secondary battery 5 by using an electric current value of the vehicle drive motor 2 when he timer value is equal to or smaller than the predetermined time, while it estimates it by using an electric current value of the compressor motor 3 when the timer value is larger than the predetermined time. A detail structure of the secondary-battery internal state estimating part 13 will be later described.

Herein, the detail structure of the vehicle running state judging part 10 will be described.

The vehicle running state judging part 10 includes an upper-limit value outputting part 101, a lower-limit value outputting part 102, a first comparator 103, a second comparator 104, AND logic operator 105, the timer 106, a predetermined time outputting part 107 and a third comparator 108.

The upper limit value outputting part 101 sets, allowing for a legal speed, a vehicle performance and so forth, and outputs the upper limit value X1 at which the motor vehicles runs at a substantially constant vehicle speed on an express highway and the like.

The lower limit value outputting part 102 sets, allowing for the legal speed, the vehicle performance and so forth, and outputs the lower limit value X2 at which the motor vehicles runs at a substantially constant vehicle speed on the express highway and the like.

The first comparator 103 receives the detected vehicle speed and the upper limit value X1 from the vehicle speed sensor 6 and the upper limit value outputting part 101, respectively, to compare them with each other. If the detected vehicle speed is equal to or smaller than the upper limit value X1, it outputs a first comparison signal "1", which indicates "truth", or "ON", while if it is larger than the upper limit value X1, it outputs the first comparison signal "0", which indicates "false", or "OFF.

The second comparator 104 receives the detected vehicle speed and the lower limit value X2 from the vehicle speed sensor 6 and the lower limit value outputting part 102, respectively, to compare them with each other. If the detected vehicle speed is equal to or larger than the lower limit value X2, it outputs a second comparison signal "1", which indicates "truth", or "ON", while if it is smaller than the lower limit value X2, it outputs the second comparison signal "0", which indicates "false", or "OFF.

The AND logic operator 105 receives the first comparison signal and the second comparison signal from the first comparator 103 and the second comparator 104, respectively, and it outputs a condition-satisfaction signal "1", which indicates that a condition where the vehicle runs at a speed within the upper and lower limit values X1 and X2 is satisfied, to the timer 106 when the first comparator 103 and the second comparator output "1", namely "truth". This means that the motor vehicle is running at the substantially constant vehicle speed on an express highway or the like. On the other hand, it outputs the condition-satisfaction signal "0" when the condition is not satisfied, which means that the vehicle runs at a speed more than the upper limit value X1 or less than the lower limit value X2.

The timer 106 starts to count up when it receives the condition-satisfaction signal from the AND logic operator 105, and continues to output its counting time as long as it receives the condition-satisfaction signal.

The predetermined time outputting part 107 sets the predetermined time Tp, which the vehicle needs to be judged that it is running at the substantially constant vehicle speed on the express highway or the like, and it outputs the predetermine time Tp to the third comparator 108.

The third comparator 108 receives the counting time and the predetermined time Tp from the timer 106 and the predetermined time Tp outputting part 107, respectively, and it compares them with each other. If the counting time is larger than the predetermined time Tp, it outputs a third comparison signal "1" to the electric-current random-noise impression commanding part 12 and the shifting part 11, while if the counting time is equal to or smaller than the predetermined time Tp, it outputs the third comparison signal "0" thereto.

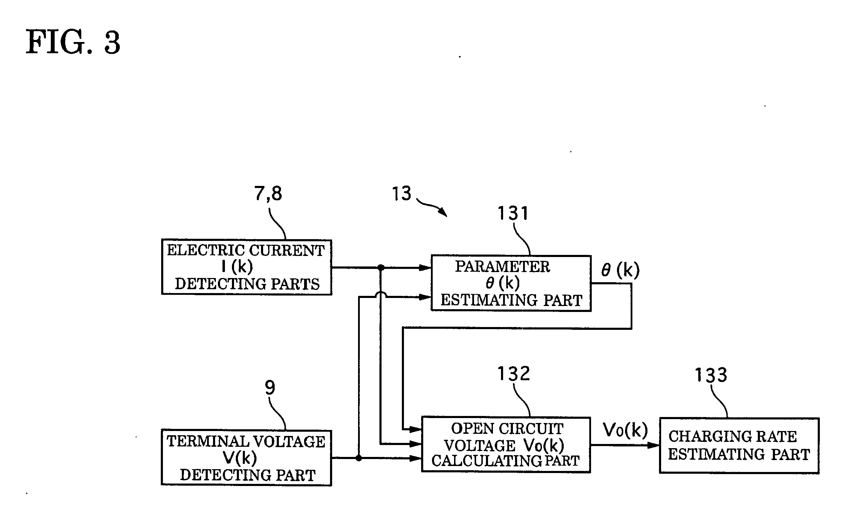

Next a detail structure of the secondary-battery internal state detecting part 13 will be described with reference to the drawing of FIG 3.

Although a structure of the secondary-battery internal state estimating part 13 is similar to that disclosed in Japanese Patent Application Laid-open Publication No. 2004 - 178848, a brief explanation thereof will be described.

The secondary-battery internal state estimating part 13 includes a parameter estimating part 131, an open-circuit voltage calculating part 132 and a charging rate estimating part 133.

The parameter estimating part 131 is electrically connected to the electric current detecting parts 7 and 8 and the secondary-battery terminal voltage detecting part 9 to receive detected electric current I(k) and the a detected voltage V(k) therefrom, respectively, for estimating a parameter Θ(k) by using a not-shown adaptive digital filter. The detected electric current I(k) is one that is selected by the shifting part 11 from the vehicle drive motor electric current and the compressor motor electric current.

The open-circuit voltage calculating part 132 is electrically connected to the electric current detecting parts 7 and 8, the secondary-battery terminal voltage detecting part 9 and the parameter estimating part 131 to receive the detected electric current I(k), the detected voltage V(k) and the parameter Θ(k) therefrom for calculating a voltage value in an open circuit, where the secondary battery 5 alone is not electrically connected to a load (a motor) by using the parameter.

The charging rate estimating part 133 is electrically connected to the open-circuit voltage calculating part 132 to receive the calculated voltage value Vo(k) for estimating a charging rate (SOC) based on the detected voltage value Vo(k) by using data of characteristics between the open-circuit voltage and the charging rate.

Incidentally, a method for estimating the parameter and estimating the SOC using the parameter is disclosed in Japanese patent application laid-open publication No. 2004 - 178848, which can be applied to the internal state estimating device of the embodiment.

The operation of the internal state estimating device of the first embodiment will be described.

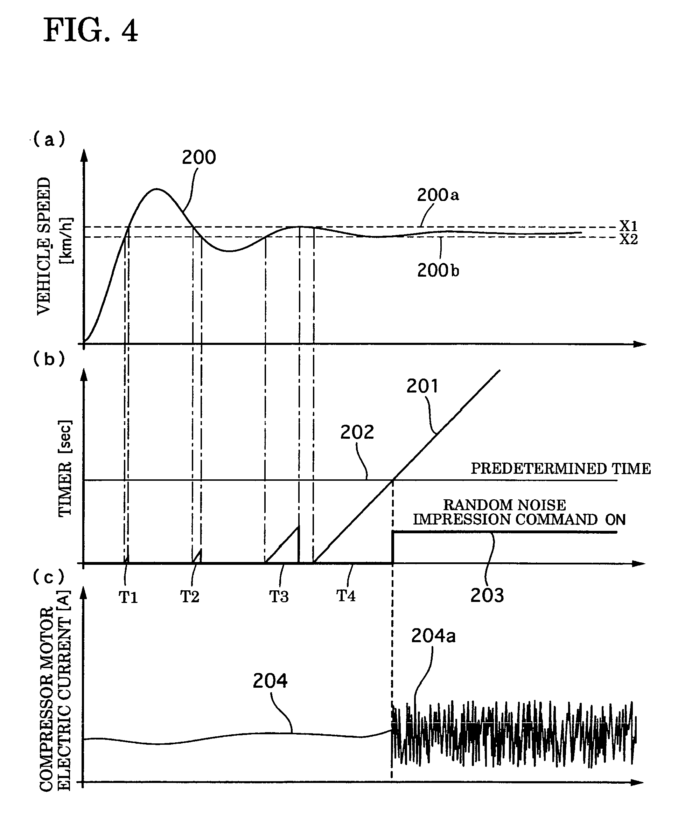

FIG 4 shows an example of a time chart of the vehicle speed, the timer value and the electric current to be supplied to the compressor motor 3 in the first embodiment.

In this example, the upper limit value X1 is set to be 110 Km/h, the lower limit value X2 is set to be 90Km/h, and the predetermined time Tp is set to be ten minutes, which are indicated by lines 200a, 200b and 202 in FIG 4, respectively.

The motor vehicle starts and increases its vehicle speed 200 as shown in a most-left portion in an upper part (a) of FIG 4. The vehicle velocity 200 detected by the vehicle speed sensor 6 is compared to the upper limit value X1 and the lower limit value X2 by the first and second comparators 103 and 104 of the vehicle running state judging part 10. The first and second comparators 103 and 104 output the first and second comparison signals "0". In this state, the AND logic operator 105 outputs the condition-satisfaction signal "0", which results in the timer 106 does not start and the third comparator 108 outputs the third comparison signal "0" as shown in an intermediate part (b) in FIG 4.

Consequently, the shifting part 11 is shifted to electrically connect the vehicle drive motor electric current detecting part 7 and the secondary-battery internal-state estimating part 13 to each other, disconnecting the secondary-battery internal-state estimating part 13 from the compressor motor electric current detecting part 8. At the same time, the electric-current random-noise impression commanding part 12 outputs the command signal to the compressor motor controller 4 so that the normal electric current 204 is impressed on the compressor motor 3 as shown in a left portion of a lower part (c) in Fig. 4. In this state, the vehicle drive motor electric current varies at a degree enough for detection of the internal state of the secondary battery 5 with high accuracy.

The vehicle speed 200 soon reaches the lower limit value X2, not reaching the upper limit value X1, which makes the first and second comparator 103 and 104 output the first and second comparison signals "1", so that the timer 106 starts to count up. Then the vehicle speed 200 rapidly increases and exceeds the upper limit value X1, thus the comparator 103b outputting the first comparison signal "0". The AND logic operator 105 outputs the condition-satisfaction signal "0" to stop counting-up of the timer 106. This counting time T1 counted by the timer 106 is compared by the third comparator 108, which does not change its output "0" because the counting time T1 is smaller than the predetermined time Tp.

Subsequently, the vehicle speed 200 repeats to rise and fall, the timer 106 outputs the counting times T2 and T3 in each period where the condition is satisfied. These counting times T2 and T3 are smaller than the predetermined time Tp, thus the shifting part 11 and the electric-current random-noise impression part 12 being unchanged.

Then the dropped vehicle speed 200 reincreases to reach the lower limit value X2, which starts the timer 106 to count up. When the vehicle speed 200 is kept at a speed within the upper and lower limit values X1 and X2 so that the counting time exceeds the predetermined time 202 as indicated by a line 201, the third comparator 103 outputs the third comparison signal "1". This means that the running state judging part 10 judges that the motor vehicle is running at the substantially constant vehicle speed on an express highway.

The third comparison signal "1" is sent to the shifting part 11 and the electric-current random-noise impression commanding part 12, so that the shifting part 11 shifts to electrically connect the secondary-battery internal-state estimating part 13 to the compressor motor electric current detecting part 8, disconnecting it from the vehicle drive motor electric current detecting part 7, and the electric-current random-noise impression commanding part 12 outputs the command signal "1", which is indicated by a line 203, to the compressor motor controller 4 to impress the random noise to the compressor motor 3. The compressor motor controller 4 superimposes the random noise on the electric current detected by the compressor motor electric current detecting part 8 so as to form a composite electric current with a random waveform 204a.

This composite electric current signal and terminal voltage detected by the secondary battery terminal voltage detecting part 9 are inputted to the secondary-battery internal-state estimating part 13. Therefore, it can estimate the internal state of the secondary battery 5 with a higher degree of accuracy, because it can use various frequency components included in the composite electric current signal, in other words, a constantly varying input value.

The operation of the secondary-battery internal-state estimating part 13 will be described in detail.

The internal-state estimating part 13 constructs an equivalent-circuit model of the secondary battery 5, which is expressed by a transfer function, to function as the adaptive digital filter for estimating the parameter and calculating the open-circuit voltage. The adaptive digital filter has a frequency characteristic of a gain and suppresses a certain frequency in an input waveform, passing the other frequency therein, so that its input value is estimated with a high degree of accuracy when its value changes, or when the input value has various frequency components. Vehicle running, at the substantially constant vehicle speed on an express highway or the like, keeps the current value of the wheel drive motor 2 to be substantially unchanged. This means that there are a few frequency components in the input current value, which deteriorates an estimation performance of the internal-state estimating part 13.

Under such a condition, the device of the first embodiment adds the random noise to the electric current to be applied to the compressor motor 3, and the internal-state device receives a current value detected by the compressor-motor electric current detecting part 8.

Therefore, it can improve the estimation of the internal state (SOC) of the secondary battery 5, so that the secondary battery 5 can be used up to the limits of charge and discharge control, and the charge and discharge can be controlled more precisely. This improves a travel distance and a running speed of the motor vehicle and life duration of the secondary battery 5.

The random noise is set to change the rotational speed of the compressor motor 5 to a degree where a passenger hardly notices the change thereof. No undesirable effects are produced on the air conditioner, thus providing no uncomfortable feeling to the passenger.

The internal state estimating device of the secondary battery of the first embodiment has the following advantage.

It can estimate the internal state of the secondary battery with a higher degree of accuracy, even when the motor vehicle, such as a hybrid electric vehicle and an electric vehicle, is running at the substantially constant vehicle speed on the express highway, a long frat road and the like.

Next, an internal state estimating device of a secondary battery of a second embodiment according to the present invention will be described with reference to the accompanying drawings.

In the second embodiment, a secondary-battery internal-state estimating part has a highpass filter into which a detected vehicle speed signal is inputted.

A running state judging part 10 is provided with a highpass filter 111 that is electrically connected between a vehicle speed sensor 6 and a first comparator 103 and also between the vehicle speed sensor 6 and a second comparator 104. The highpass filter 111 receives a vehicle speed signal from the vehicle speed sensor 6 to suppress passing-through of low frequency thereof, while it passes high frequency therethrough as a highpassed vehicle speed signal to the first and second comparators 103 and 104.

An upper-limit value outputting part 109 sets an upper limit value by adding a predetermined value to an input value outputted from the vehicle speed sensor 6, and outputs the upper limit value. A lower-limit value outputting part 110 sets a lower limit value by subtracting a predetermined value from the input value, and outputs the lower limit value. The setting time of the upper and lower limit values is at a start time of judging a running state.

The other parts of the second embodiment are constructed similarly to those of the first embodiment.

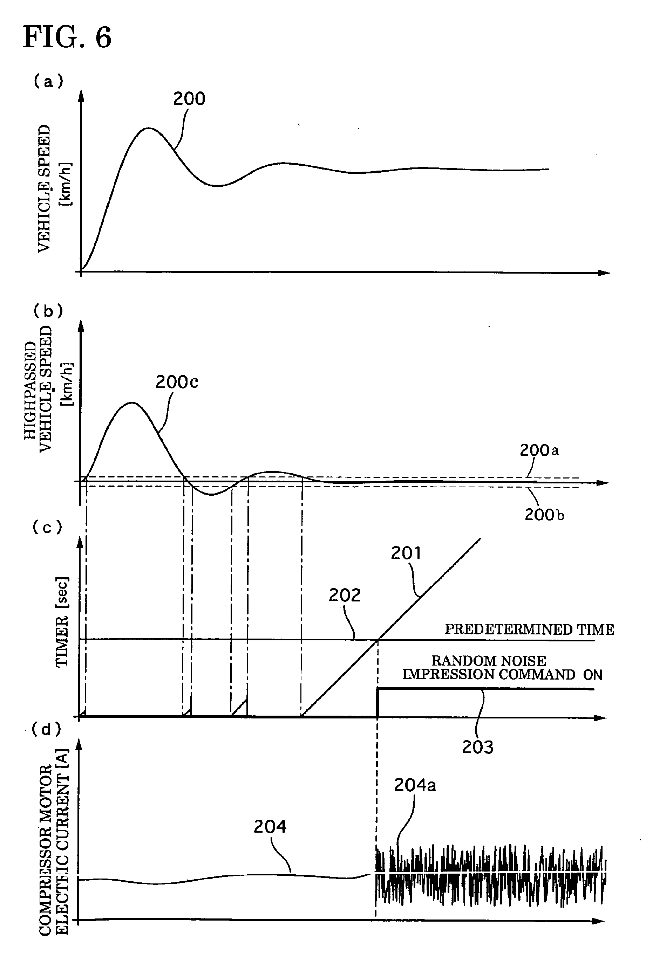

FIG 6 shows an example of a time chart of the vehicle speed, the vehicle speed after it passes through the highpass filter 111, a timer value and the electric current to be supplied to the compressor motor 3 in the second embodiment.

In the second embodiment, the running state judging part 10 judges, based on an input value (a value of the vehicle speed signal) 200c obtained from a vehicle speed (200) signal by the highpass filter 111, that a motor vehicle is running at a substantially constant speed, if the input value 200c is kept within the upper and the lower limit values 109a and 110a for more than a predetermined time.

As seen in (c) of FIG. 6, when the input value 200c enters a in-value area within the upper and lower limit value 109a and 110a, a timer 106 starts to count up as shown as T1', T2' and T3'. In the periods of T1' and T2', counting time of the timer 106 stops counting-up because the input value 200c departs from the in-value area before the counting time exceeds the predetermined time, thus an electric-current random-noise impression commanding part 12 from outputting a command signal "0 and a shifting part 11 connecting a vehicle drive motor electric current detecting part 7 and a secondary-battery internal-state estimating part 13.

On the other hand, in the period of T3', the counting time exceeds the predetermined time, so that a third comparator 108 outputs a third comparison signal "1". This makes the electric-current random-noise impression commanding part 12 output the command signal "1" and also makes the shift part 11 connect the compressor motor electric current detecting part 8 and the secondary-battery internal-state estimating part 13.

Therefore, a compressor motor controller 4 impresses a random noise to a compressor motor electric current 204 so as to form a composite electric current with a random waveform 204a as seen in (d) of FIG 6, and the secondary-battery internal-state estimating part 13 estimates an internal-state of a secondary battery 5 with high.

In this second embodiment, using the highpass filter 111 and the upper and lower limit value outputting parts 109 and 110 enables the running state judging part 10 to judge a substantially constant speed running state, in a different in-value area such as a low speed area smaller than that in the first embodiment where fixed limit values (90 Km/h and 110 Km/h for example) are used.

The internal state estimating device of the second embodiment has the following advantage in addition to that of the first embodiment.

The internal state of the secondary battery 5 can be estimated wit high accuracy while the motor vehicle is running at a substantially constant vehicle speed regardless of a high constant speed or a low constant speed.

Next an internal state estimating device of a secondary battery of a third embodiment according to the present invention will be described with reference to the accompanying drawings.

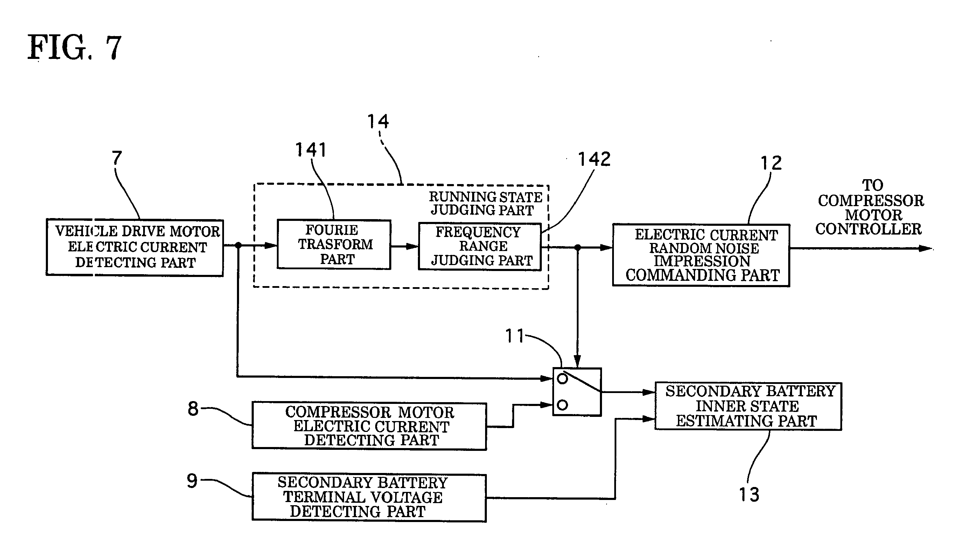

FIG 7 shows a block diagram of the internal state estimating device of the third embodiment.

The internal state estimating device of the third embodiment has a running state judging part 14 constructed differently from that of the first and second embodiments. The running state judging part 14 includes a Fourier transform part 141 and a frequency range judging part 142, and is inputted with a vehicle drive motor electric current signal from a vehicle drive motor electric current detecting pat 7, instead of the vehicle speed signal outputted from the vehicle speed sensor 6 like the first and second embodiments. The Fourier transform part 141 corresponds to a Fourier transform means of the present invention, and the frequency range judging part 142 corresponds to a frequency range judging means of the present invention.

The Fourier transform part 141 extracts frequency components by using Fourier transform of a detected motor current signal outputted from the vehicle drive motor electric current detecting pat 7, and outputs a frequency component signal to the frequency range judging part 142.

The frequency range judging part 142 outputs a judgment signal "0" when an amplitude of the frequency component signal in a certain frequency range is equal to or more than a predetermined value to estimate the internal state of a secondary battery 5 based on an electric current value of a vehicle drive motor 2. It outputs the judgment signal "1" when the amplitude of the frequency component signal in the certain frequency range is smaller than the predetermined value, it adds random noise to the electric current to be supplied to a compressor motor 3 to estimate the internal state of the secondary battery 5 based on the electric current with the random noise supplied to the compressor motor 3.

The other parts of the third embodiment are constructed similarly to those of the first embodiment.

The operation of the internal state estimating device of the third embodiment will be described.

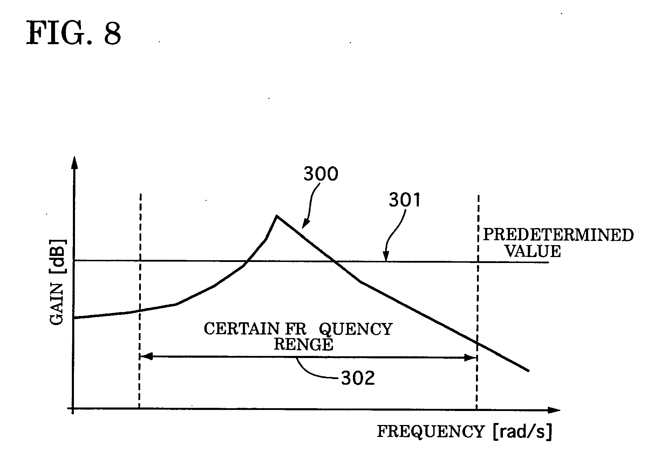

FIG. 8 shows an example of a relationship between the frequency and a gain.

In the third embodiment, the Fourier transform part 141 extracts the frequency components by using Fourier transform of the detected motor current signal outputted from the vehicle drive motor electric current detecting pat 7. Then the frequency range judging part 142 judges whether or not the amplitude of is within the certain frequency range. Specifically, it judges a frequency of the electric current value by detecting that a gain (the attitude) 300 exceeds the predetermined value, indicated by a line 301 in FIG 8, in the certain frequency range indicated by arrow 302.

If the gain does not exceed the predetermined value in the certain frequency range, the vehicle drive electric current supplied to the vehicle drive motor 2 is substantially constant. In this case, the judgment signal, corresponding to a signal of a running state judging part 14, is set to be "1", so that a compressor motor controller 4 adds the random noise to the compressor motor electric current to be supplied to a compressor motor 4, and a shift part 11 electrically connects a secondary-battery internal-state estimating 13 to a compressor motor electric current detecting part 8.

The secondary-battery internal-state estimating part 13 estimates the internal state of the secondary battery 5 based on the compressor motor electric current with the random noise detected by the compressor motor electric current detecting part 8 and a secondary-battery terminal voltage detected by a secondary-battery terminal-voltage detecting part 9. The compressor motor electric current with the random noise has various frequency components, which the secondary-battery internal-state estimating part 13 to estimate the internal state with high accuracy.

The internal state estimating device of the third embodiment has the following advantage in addition to that of the first embodiment.

It does not need a vehicle speed sensor, which can decrease its manufacturing costs.

Next an internal state estimating device of a secondary battery of a fourth embodiment according to the present invention will be described with reference to the accompanying drawings.

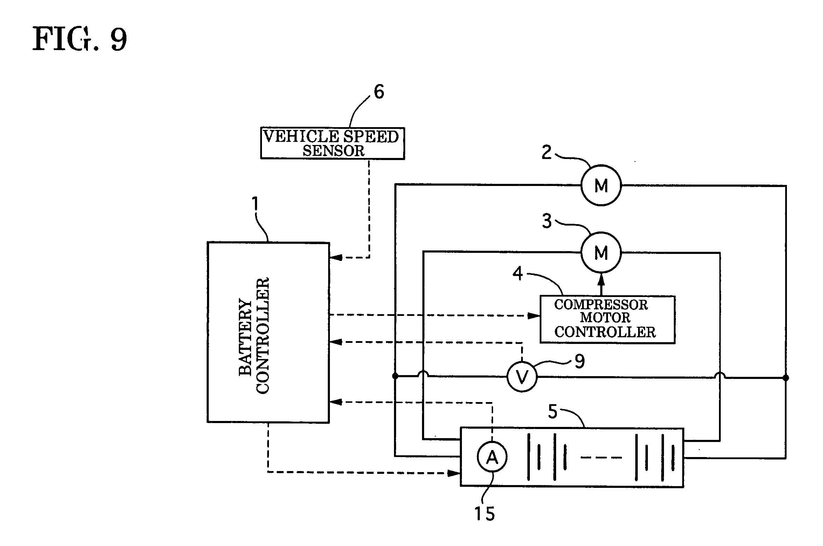

FIG 9 shows a block diagram of the internal state estimating device of the secondary battery 5 of the fourth embodiment.

In the internal state estimating device of the fourth embodiment, a total electric current value of a vehicle drive motor electric current value and a compressor motor electric current value is detected by a secondary-battery electric current detecting part 15 for detecting a total electric current value of an electric current of the total electric current, instead of using a vehicle drive motor electric current detecting part and a compressor motor electric current detecting part. The secondary-battery electric current detecting part 15 corresponds to the electric current detecting means of the present invention.

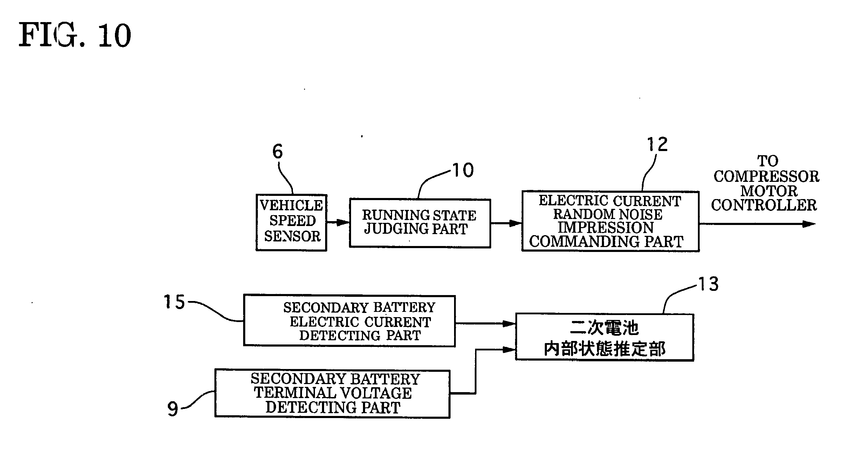

FIG 10 shows a block diagram of an estimating part of a battery controller 1. The battery controller 1 corresponds to the internal state estimating device of the present invention.

In the estimating part of the battery controller 1, a running state judging part 10 receives a vehicle speed signal from a vehicle speed sensor 6 to output a judgment signal to an electric-current random-noise impression commanding part 12 as well as those in the first embodiment. The secondary-battery electric current detecting part 15 receives a secondary-battery electric current signal and a secondary-battery terminal-voltage signal from the secondary-battery electric current detecting part 15 and a secondary-battery terminal voltage detecting part 9, respectively. A shift part is also removed.

The other parts of the fourth embodiment are constructed similarly to those of the first embodiment.

The operation of the internal state estimating device of the secondary battery 5 of the fourth embodiment will be described.

A secondary-battery internal-state estimating part 13 estimates the internal state of the secondary battery 5 based on the electric current charged to and discharged from the secondary battery 5. When the running state judging part 10 judges a substantial constant-speed running of a motor vehicle based on the vehicle speed signal outputted from the vehicle speed sensor 6, the electric-current random-noise impression commanding part 12 of the battery controller 1 outputs a command signal "1" to the compressor motor controller to add the random noise to the vehicle drive motor electric current and drive the compressor motor 3. Therefore, the internal state of the secondary battery 5 can be estimated with high accuracy. When the command signal "0" is outputted, the compressor motor electric current is supplied to the compressor motor 3 without the random noise. In this state, the vehicle drive motor electric current varies so that the internal state can be estimated with high accuracy.

The internal state estimating device of the fourth embodiment has the following advantage in addition to that of the first embodiment.

It only needs the secondary-battery electric current detecting part instead of a vehicle drive motor electric current detecting part and a compressor motor electric current detecting part, which can decrease its manufacturing costs.

While there have been particularly shown and described with reference to preferred embodiments thereof, it will be understood that various modifications may be made therein.

In the first to fourth embodiments, the compressor motor 3 is employed as a load motor, while the load motor may be other motor.

## Claims

1. An internal state estimating device of a secondary battery (5) comprising:
an electric current detecting means (7, 8; 15) for detecting one of a total electric current, of a vehicle drive motor electric current to be supplied to a vehicle drive motor (2) and a load-motor electric current to be supplied to a load-motor (3), and each electric current thereof;
a secondary-battery terminal voltage detecting means (9) for detecting a terminal voltage of the secondary battery (5);
a running state judging means (10, 14) for judging a substantially constant vehicle-speed running state of a motor vehicle;
an electric-current random-noise impressing means (12) for impressing the load-motor electric current, to be supplied to the load motor (3), superimposed with a random noise having a plurality of frequency components to the load motor (3) when the running state judging means (10, 14) judges the substantially constant vehicle-speed running state; and
a secondary-battery internal-state estimating means (13) for estimating an internal state of the secondary battery (5) based on the terminal voltage and the one of the electric current that includes the load-motor electric current and is superimposed with the random noise when the running state judging means judges (10, 14) the substantially constant vehicle-speed running state.

2. The internal state estimating device of the secondary battery (5) according to claim 1, wherein the electric current detecting means (7, 8) includes a vehicle drive motor electric current detecting means (7) for detecting a vehicle drive motor electric current to be supplied with the vehicle drive motor (2) and a load-motor electric current detecting means (8) for detecting a load-motor electric current (3), and wherein the one of the electric current on which the secondary-battery internal-state estimating means (13) estimates the internal state based is the load-motor electric current.

3. The internal state estimating device of the secondary battery (5) according to claim 1, wherein the electric current detecting means (15) detects a secondary-battery electric current charged to and discharged from the secondary battery (5), and wherein the one of the electric current on which the secondary-battery internal-state estimating means (13) estimates the internal state based is the secondary battery electric current.

4. The internal state estimating device of the secondary battery (5) according to any one of claims 1 to 3, further comprising:
a vehicle speed sensor (6) for detecting a vehicle speed of the motor vehicle to output a vehicle speed signal, wherein
the running state judging means (10; 14) has a highpass filter (111) for suppressing low frequency of the vehicle speed signal, and the running state judging means (10; 14) judges the substantially constant vehicle-speed running state when a highpassed vehicle speed signal, obtained from the vehicle speed signal by using the highpass filter (111), is kept at the substantially constant vehicle speed for a predetermined time.

5. The internal state estimating device of the secondary battery (5) according to claim 1 or claim 2, wherein the running state judging means (10; 14) includes a Fourie transform means (141) for extracting frequency components from the vehicle drive motor electric current by using Fourier transform to output a frequency component signal, and a frequency range judging means (142) for judging the substantially constant vehicle-speed running state when a gain of the frequency component signal does not exceed a predetermined value in a certain frequency range.
